# EUROPÄISCHE PATENTSCHRIFT

(11) **EP 3 303 658 B1**
(45) Veröffentlichungstag und Bekanntmachung des Hinweises auf die Patenterteilung: **03.05.2023**
(21) Anmeldenummer: 16728635.0
(22) Anmeldetag: 25.05.2016
(51) Int. Cl.: C25B 11/043, C01B 33/02

(54) **VERFAHREN ZUM HERSTELLEN EINER DIAMANT-ELEKTRODE UND DIAMANT-ELEKTRODE**
METHOD FOR PRODUCING A DIAMOND ELECTRODE AND DIAMOND ELECTRODE
PROCÉDÉ DE FABRICATION D'UNE ÉLECTRODE DIAMANT ET ÉLECTRODE DIAMANT

(30) Priorität: 26.05.2015 DE 102015006514
(43) Veröffentlichungstag der Anmeldung: 11.04.2018
(73) Patentinhaber: CONDIAS GMBH, 25524 Itzehoe (DE)
(72) Erfinder: FRYDA, Matthias, 25524 Itzehoe (DE); MATTHÉE, Thorsten, 25582 Hohenaspe (DE)
(74) Vertreter: Gramm, Lins & Partner Patent- und Rechtsanwälte PartGmbB
(86) Internationale Anmeldenummer: PCT/EP2016/061833
(87) Internationale Veröffentlichungsnummer: WO 2016/189050

(56) Entgegenhaltungen:
- EP-A1- 1 953 271
- EP-A1- 2 657 370
- GB-A- 2 483 769
- JP-A- 2011 046 994
- JP-A- 2012 144 779
- US-A1- 2013 313 120

## Beschreibung

Die Erfindung betrifft ein Verfahren zum Herstellen einer Diamant-Elektrode sowie eine nach diesem Verfahren herstellbare Diamant-Elektrode.

Diamant-Elektroden werden heute in einer Vielzahl unterschiedlicher Anwendungen insbesondere verwendet. Bei der Prozessorherstellung wird heute eine Vielzahl unterschiedlicher Schichten mit filigranen Strukturen aufgebracht. Um eine ordnungsgemäße Funktionsweise zu gewährleisten, müssen die zu beschichtenden Oberflächen regelmäßig gereinigt und konditioniert werden. Im Schnitt werden zwei bis drei Reinigungs- und Oberflächenkonditionierungsprozesse pro aufzubringender Schicht durchgeführt. Unterschiedliche Arten von Verunreinigungen müssen dabei durch unterschiedliche Arten von Reinigungsflüssigkeiten entfernet werden. Für organische Verunreinigungen wird beispielsweise ozonisiertes Wasser verwendet, während zum Entfernen von auf der Oberfläche angeordneten Partikeln kathodisches Wasser verwendet wird. Anodisches Wasser wird beispielsweise verwendet, um metallische Verunreinigungen zu entfernen. Um Oberflächen und letzte Verunreinigungen zu entfernen, kann auch ein spezielles anodisches Wasser verwendet werden, das eine Mischung aus verdünnter Flusssäure und Ozon enthält.

Zur Herstellung aller dieser Reinigungslösungen können heute Diamant-Elektroden in entsprechenden Elektrodenanordnungen verwendet werden.

Diamant-Elektroden können aus massiven Diamant-Einkristallen bestehen, sind in dieser Ausgestaltung jedoch sehr teuer. Es ist daher aus dem Stand der Technik bekannt, Diamant-Elektroden aus einem Grundmaterial herzustellen, das mit einer dünnen Diamantschicht beschichtet wird. Dabei wird als Grundmaterial oft ein Metall verwendet, damit die zur Herstellung der unterschiedlichen Reinigungslösungen nötigen Ströme gut zur Elektrodenoberfläche geleitet werden können.

Nachteilig ist jedoch, dass Metallelektroden, die lediglich mit einer Diamantschicht beschichtet sind, die Gefahr bergen, dass es in der Reinigungslösung zu metallischen Verunreinigungen kommt. Zudem lassen sich metallische Werkstoffe in der benötigten Exaktheit nur mit sehr aufwendigen Verfahren bearbeiten, die entsprechend kostenintensiv sind.

JP2011046994, US2013/313120 und JP2012-144779 offenbaren Diamant-Elektroden.

Der Erfindung liegt daher die Aufgabe zugrunde, ein Verfahren zum Herstellen einer Diamant-Elektrode vorzuschlagen, das kostengünstig und exakt durchführbar ist und auch für die Herstellung von Diamant-Elektroden in großen Stückzahlen geeignet ist.

Die Erfindung löst die gestellte Aufgabe durch ein Verfahren zum Herstellen einer Diamant-Elektrode, das die folgenden Schritte aufweist:
a) Bereitstellen eines Grundkörpers aus Silizium, dessen Abmessungen größer sind als die der herzustellenden Diamant-Elektrode,
b) Ätzen wenigstens einer Vertiefung in einer Oberfläche des Grundkörpers,
c) Einbringen von Sollbruchstellen in den Grundkörper,
d) Diamantbeschichten des Grundkörpers,
e) Herausbrechen der Diamant-Elektrode aus dem Grundkörper entlang der Sollbruchstellen.

Überraschenderweise hat sich gezeigt, dass Silizium als Material für den Grundkörper einer Diamantelektrode geeignet ist, obwohl es als Halbleiter eine Bandlücke aufweist. Diese verhindert normalerweise insbesondere bei kleinen Spannungen einen Stromfluss, so dass Silizium zunächst als Grundmaterial nicht als geeignet erscheint. Es ist bekannt, die Leitfähigkeit des Siliziums durch Dotierungen zu erhöhen. Derartig hochdotiertes Silizium lässt sich jedoch nur sehr schlecht einem kontrollierten Ätzprozess unterziehen, sodass die Verbesserung der Leitfähigkeit eine Verschlechterung der Verarbeitbarkeit zur Folge hat. Überraschenderweise wird eine derartige Dotierung jedoch nicht benötigt. Es hat sich herausgestellt, dass die auf der Außenseite des Grundkörpers aufgebrachte Diamant-Beschichtung ausreichend ist, um die benötigten elektrischen Ströme zu transportieren. Mit dieser überraschenden Erkenntnis kann nun auf die aus der Halbleitertechnologie bekannten Verarbeitungs- und Herstellungsprozesse zurückgegriffen werden, die bereits hochgradig optimiert und für die Massenfertigung geeignet sind.

Vorteilhafterweise wird zunächst auf den Grundkörper aus Silizium eine Siliziumdioxid (SiO₂)-Adhäsionsschicht aufgebracht, die ca. 50 nm dick ist. Sie dient als Haftvermittler für eine darauf aufzubringende Isolationsschicht, die beispielsweise 150 nm dick sein kann und vorzugsweise aus Siliziumnitrid (Si₃N₄) besteht. Darauf wird in einem bekannten Verfahren eine photoaktive Schicht aufgebracht, die anschließend belichtet wird. Dies kann über herkömmliche Verfahren geschehen, wie sie dem Fachmann beispielsweise als Maskenbelichtungsverfahren bekannt sind.

Durch ein ebenfalls bekanntes lonen-Ätz-Verfahren werden die Isolationsschicht und die Adhäsionsschicht entfernt, sodass an den belichteten Stellen das Material des Grundkörpers frei zugänglich ist. All dies dient der Vorrichtung des eigentlichen Ätz-Verfahrens im Verfahrensschritt b). Das Ätzen selber erfolgt vorteilhafterweise mit einer eine Kaliumlauge (KOH). Anschließend werden die Reste der aufgebrachten Adhäsions- und der Isolationsschicht entfernt. Dies kann beispielsweise durch Ätzen mit verdünnter Flusssäure (HF) geschehen. Nachdem der Ätz-Prozess abgeschlossen ist, werden Sollbruchstellen in den Grundkörper eingebracht, bevor dieser Diamant beschichtet wird. Nach dem Beschichten des Grundkörpers mit der Diamantschicht wird der Grundkörper entlang dieser Sollbruchstellen gebrochen. Dabei können eine oder mehrere Diamant-Elektroden gleichzeitig aus dem gleichen Grundkörper hergestellt werden, wodurch die Massenproduktion vereinfacht und das entsprechende Herstellungsverfahren kostengünstiger durchführbar wird.

Vorteilhafterweise handelt es sich bei dem Grundkörper um einen Silizium-Einkristall. Derartige Einkristalle werden heute beispielsweise in der Halbleiter-Industrie in großen Mengen verwendet und sind entsprechend kostengünstig auf dem Markt erhältlich.

In einer bevorzugten Ausgestaltung verfügt die wenigstens eine Vertiefung über wenigstens eine Flanke, die entlang einer vorbestimmten Kristallebene des Grundkörpers verläuft. Es hat sich herausgestellt, dass unterschiedliche Kristallgitterebenen im Silizium-Einkristall unterschiedliche Ätzgeschwindigkeiten aufweisen. So hat man beispielsweise für monokristallines Silizium festgestellt, dass die (111)-Ebene etwa 400-mal langsamer als die (100)-Ebene geätzt werden kann. Auf diese Weise lassen sich Flanken ätzen, die einen durch die Kristallstruktur des verwendeten Materials fest vorgegebenen Neigungswinkel aufweisen und daher auf besonders einfache Weise sehr exakt herstellbar sind.

Vorzugsweise verfügt die wenigstens eine Vertiefung über mehrere, bevorzugt vier, Flanken, von denen mehrere, vorteilhafterweise alle, entlang einer vorbestimmten Kristallebene verlaufen. Auf diese Weise lässt sich nicht nur der Neigungswinkel einer Flanke, sondern der Neigungswinkel einfach und exakt herstellen.

Es hat sich als vorteilhaft herausgestellt, dass die vorbestimmten Kristallebenen <111>-Ebenen sind. Durch diese Notation wird vorliegend die Menge der raumdiagonalen Ebenen der Kristallstruktur beschrieben. Jede der so benannten Kristallebenen ist folglich eine der acht möglichen raumdiagonalen Ebenen. Ein Silizium-Einkristall liegt in der Diamantstruktur, also einem kubisch-flächenzentrierten Gitter vor. Die acht raumdiagonalen Ebenen sind folglich kristallografisch gleichwertig. Daher ist es möglich, auch die in unterschiedliche Richtungen verlaufenden Flanken der Vertiefung durch Ätzprozesse so herzustellen, dass sie entlang dieser Ebenen verlaufen.

Als vorteilhaft hat sich herausgestellt, wenn die wenigstens eine Vertiefung einen Durchbruch durch den Grundkörper bildet. Auf diese Weise ist er später durch die Flüssigkeit, die durch die Elektrode elektrochemisch behandelt werden soll, gut umspülbar. Zudem entstehen insbesondere an der Unterseite, an der der Durchbruch durch das Ätzen von der Oberseite ausgehend vollendet wird, scharfe Kanten, die einen sehr kleinen Krümmungsradius aufweisen. An dieser Stelle findet folglich zumindest ein Großteil der elektrochemischen Behandlung und der dabei auftretenden Reaktionen statt. Wird die wenigstens eine Vertiefung als Durchbruch ausgebildet, kann die Flüssigkeit, die es elektrochemisch zu behandeln gilt, auch an dieser Stelle einfach entlangströmen.

Vorzugsweise werden mehrere Vertiefungen gleichzeitig in die Oberfläche des Grundkörpers geätzt, die besonders vorteilhafterweise identisch ausgebildet sind.

In einer bevorzugten Ausgestaltung des Verfahrens werden die Sollbruchstellen in den Grundkörper gesägt. Sie bestehen folglich insbesondere aus einer gegebenenfalls starken Dickenreduzierung. Es hat sich als vorteilhaft herausgestellt, wenn die Dicke des Grundkörpers an der Sollbruchstelle auf höchstens 30%, vorteilhafterweise höchstens 20%, besonders vorteilhafterweise höchstens 10% der Dicke des Grundkörpers vor dem Einbringen der Sollbruchstellen reduziert wird. Je geringer die Restdicke ist, desto einfacher lässt sich die Diamant-Elektrode später aus dem Grundkörper herausbrechen. Allerdings steigt die Anfälligkeit gegenüber Erschütterungen und Stößen während des Hersteliungsprozesses.

Vorzugsweise wird eine Dicke des Grundkörpers auf einen vorbestimmten Wert reduziert, bevor der Grundkörper Diamant beschichtet. Es hat sich als vorteilhaft herausgestellt, den Grundkörper bis zu diesem Zeitpunkt in einer Dicke zu behandeln, die der üblicherweise in der Halbleitertechnik verwendeten Dicke entspricht. Auf diese Weise können die für die Halbleitertechnik optimierten Verfahren und die zum Durchführen der Verfahren benötigten Vorrichtungen und Maschinen verwendet werden, ohne dass teure Neuentwicklungen, Sonderanfertigungen oder sonstige Änderungen nötig sind. Gegebenenfalls wird jedoch eine Diamant-Elektrode benötigt, deren Dicke geringer ist als die Dicke, in der der Grundköper ursprünglich vorliegt. In diesem Fall kann die Dicke vollflächig auf den vorbestimmten Wert reduziert werden. Dies kann beispielsweise durch Schleifverfahren geschehen.

Die Erfindung löst die gestellte Aufgabe zudem durch eine Diamant-Elektrode, die nach einem der hier beschriebenen Verfahren herstellbar ist.

Mit Hilfe der beiliegenden Figuren wird nachfolgend ein Ausführungsbeispiel der vorliegenden Erfindung näher erläutert. Es zeigt
- Figur 1 -: verschiedene Stadien beim Durchführen eines Verfahrens gemäß einem ersten Ausführungsbeispiel der vorliegenden Erfindung,
- Figur 2 -: mehrere noch nicht vereinzelte Diamant-Elektroden und
- Figur 3 -: einen vergrößerten Ausschnitt einer Diamant-Elektrode.

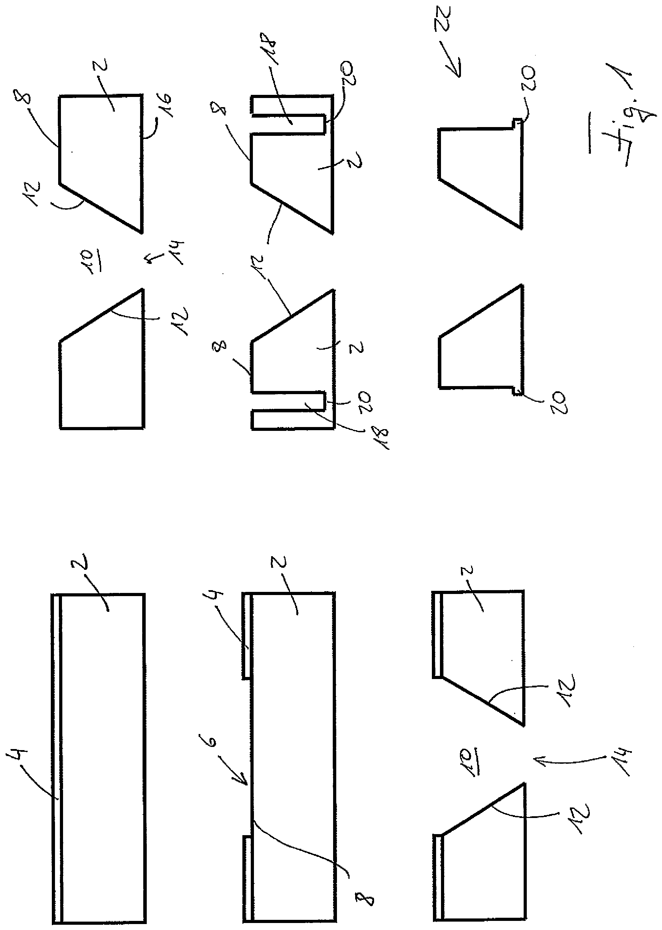

Figur 1 zeigt verschiedene Schritte beim Durchführen eines Verfahrens gemäß einem ersten Ausführungsbeispiel der vorliegenden Erfindung Auf einen Grundkörper 2 wurde im gezeigten Ausführungsbeispiel zunächst eine fotoaktive Schicht 4 aufgebracht. Zuvor kann es nötig sein, auf den Grundkörper 2, der aus Silicium besteht, weitere Schichten, beispielsweise eine Adhäsionsschicht aus Siliciumdioxid (SiO₂) und/oder eine Isolationsschicht aufzubringen, die vorteilhafterweise aus Siliciumnitrit (Si₃N₄) besteht. Diese Schichten sind je nach verwendeten fotoaktiven Schichten notwendig oder vorteilhaft, jedoch aus Übersichtlichkeitsgründen in Figur 1 nicht dargestellt. Der Grundkörper 2 mit der darauf aufgebrachten fotoaktiven Schicht 4 ist in der oberen linken Abbildung der Figur 1 dargestellt.

In der darunter gezeigten Abbildung ist die fotoaktive Schicht 4 beispielsweise durch Belichten bearbeitet worden. Sie weist daher eine Lücke 6 auf, in der eine Oberfläche 8 des Grundkörpers 2 frei zugänglich ist.

In der unteren linken Darstellung aus Figur 1 ist die Situation nach dem Ätzen wenigstens einer Vertiefung 10 in den Grundkörper 2 gezeigt. Dies kann beispielsweise mittels Kaliumlauge (KOH) geschehen. Aufgrund der besonderen Eigenschaften des Grundkörpers 2 aus Silicium verfügt die Vertiefung 10 über Flanken 12, die entlang vorbestimmter Kristallebenen verlaufen. Bei Silicium sind unterschiedliche Kristallebenen unterschiedlich leicht durch Ätzen entfernbar. Da sich die Flanken 12 entlang vorbestimmter Kristallebenen erstrecken, ist der Neigungswinkel, den die Flanke 12 relativ zur Oberseite 8 oder der gegenüberliegenden Unterseite des Grundkörpers 2 einschließt, sehr exakt herstellbar und reproduzierbar. Im gezeigten Ausführungsbeispiel ist die Vertiefung 10 durchgehend und erzeugt somit einen Durchbruch 14 durch den Grundkörper 2.

Im nächsten Verfahrensschritt, dessen Ergebnis in Figur 1 oben rechts dargestellt ist, werden auf dem Grundkörper 2 aufgebrachte Schichten entfernt. Dies kann beispielsweise durch einen Ätzprozess mit verdünnter Flusssäure (HF) erfolgen. Zusätzlich dazu kann eine Höhe oder Dicke des Grundkörpers 2, die durch den Abstand zwischen der Oberfläche 8 und der gegenüberliegenden Unterseite 16 definiert wird, auf das gewünschte Maß reduziert werden. Dies kann beispielsweise über Schleifvorrichtungen geschehen.

Anschließend werden in dem Grundkörper 2 Sollbruchstellen 18 eingebracht, so dass sich das in Figur 1 in der rechten mittleren Darstellung gezeigte Bild ergibt. Die Sollbruchstellen 18 können beispielsweise als Vertiefungen in die Oberfläche 8 des Grundkörpers 2 gesägt werden, so dass nur ein geringer Steg 20 aus dem Silicium des Grundkörpers 2 übrig bleibt. Erst nach diesem Schritt wird vorteilhafterweise der Grundkörper 2 diamantbeschichtet. Dies erfolgt über aus dem Stand der Technik herkömmliche und bekannte Verfahren. Anschließend kann die Diamantelektrode 22 vereinzelt werden, indem die Stege 20 an den Sollbruchstellen 18 zerbrochen werden. Dadurch wird die Diamantelektrode 22 herausgebrochen und vereinzelt.

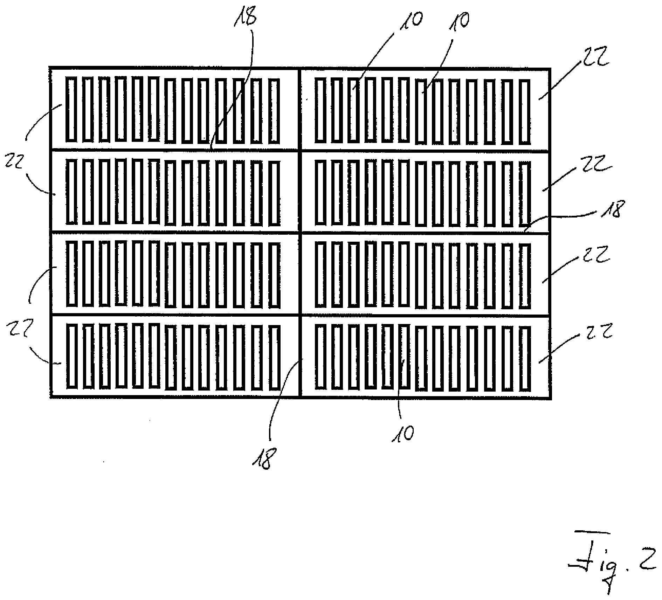

Figur 2 zeigt die Darstellung von acht Diamantelektroden 22, die noch nicht vereinzelt wurden. Die bereits beschriebenen Verfahrensschritte können beispielsweise bei einem Siliciumwafer durchgeführt werden, der beispielsweise einen Durchmesser von 200 mm aufweisen kann. Aus so einem Wafer können eine Vielzahl von Elektroden hergestellt werden, die erst im letzten Verfahrensschritt vereinzelt werden, indem die Sollbruchstellen 18 durchbrochen werden. In Figur 2 erkannt man, dass jede der gezeigten Diamantelektroden eine Vielzahl von Vertiefungen 10 aufweist. Im gezeigten Ausführungsbeispiel sind alle Diamantelektroden 22 mit der gleichen Anzahl und Anordnung von Vertiefungen 10 ausgebildet. Dies ist gegebenenfalls von Vorteil, jedoch nicht notwendig. Es ist durchaus möglich, für unterschiedliche Diamantelektroden 22 unterschiedliche Positionierungen und Anzahlen von Vertiefungen 10 vorzusehen, was beispielsweise auf besonders einfache Weise erreicht werden kann, indem unterschiedliche Masken zur Belichtung der fotoaktiven Schicht 4 verwendet werden. Zwischen den in Figur 2 dargestellten Diamantelektroden 22 befinden sich bereits Sollbruchstellen 18, die in die Oberfläche des Wafer eingesägt oder auf sonstige Weise eingebracht wurden. Entlang dieser Sollbruchstellen 18 kann der Grundkörper 2 zerbrochen und die einzelnen Diamantelektroden 22 vereinzelt werden.

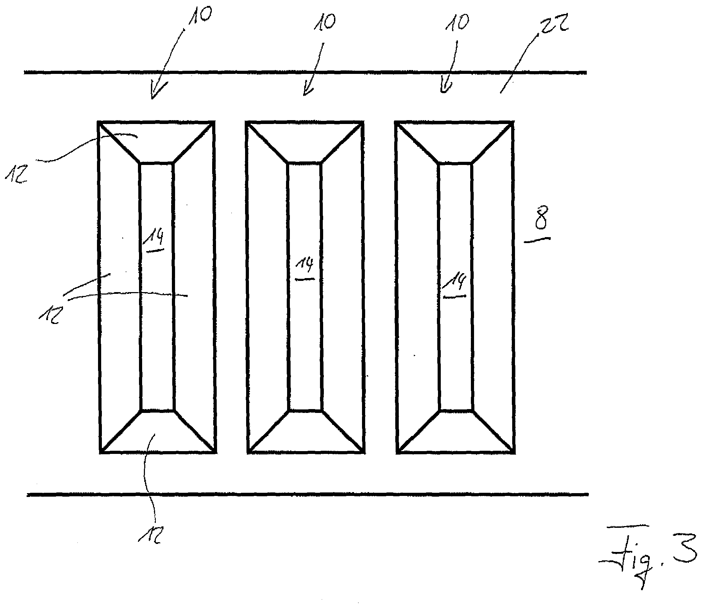

Figur 3 zeigt einen vergrößerten Ausschnitt auf einer Draufsicht auf die Oberfläche 8 einer Diamantelektrode 22. Gezeigt sind drei Vertiefungen 10, die jeweils über vier Flanken 12 verfügen, die durch Ätzen der Vertiefungen 10 entstanden sind. Auch in dem in Figur 3 gezeigten Ausführungsbeispiel sind die Vertiefungen 10 so tief, dass sie Durchbrüche 14 bilden, die zentral zwischen den Flanken 12 dargestellt sind. Die Flanken 12 erstrecken sich entlang vorbestimmter Kristallebenen des Silicium-Einkristalles, der vorteilhafterweise als Grundkörper 2 für die Diamantelektrode 22 verwendet wird. Die Neigungswinkel sind somit sehr exakt und reproduzierbar herstellbar, so dass auch die Fertigung und Herstellung großer Stückzahlen der Elektroden auf sehr einfache und dennoch genaue Weise möglich ist.

### Bezugszeichenliste

- 2: Grundkörper
- 4: fotoaktive Schicht
- 6: Lücke
- 8: Oberfläche
- 10: Vertiefung
- 12: Flanke
- 14: Durchbruch
- 16: Unterseite
- 18: Sollbruchstelle
- 20: Steg
- 22: Diamantelektrode

## Patentansprüche

1. Verfahren zum Herstellen einer Diamant-Elektrode (22), das die folgenden Schritte aufweist:
a) Bereitstellen eines Grundkörpers (2) aus Silicium, dessen Abmessungen größer sind als die der herzustellenden Diamant-Elektrode (22),
b) Ätzen wenigstens einer Vertiefung (10) in die Oberfläche (8) des Grundkörpers (2),
c) Einbringen von Sollbruchstellen (18) in den Grundkörper (2),
d) Diamantbeschichten des Grundkörpers (2),
e) Herausbrechen der Diamant-Elektrode (22) aus dem Grundkörper (2) entlang der Sollbruchstellen (18).

2. Verfahren nach Anspruch 1, **dadurch gekennzeichnet, dass** es sich bei dem Grundkörper (2) um einen Silicium-Einkristall handelt.

3. Verfahren nach Anspruch 1 oder 2, **dadurch gekennzeichnet, dass** die wenigstens eine Vertiefung (10) wenigstens eine Flanke (12) aufweist, die entlang einer vorbestimmten Kristallebene des Grundkörpers (2) verläuft.

4. Verfahren nach Anspruch 3, **dadurch gekennzeichnet, dass** die wenigstens eine Vertiefung (10) mehrere, bevorzugt vier, Flanken (12) aufweist, von denen mehrere, bevorzugt alle, entlang einer vorbestimmten Kristallebene verlaufen.

5. Verfahren nach Anspruch 3 oder 4, **dadurch gekennzeichnet, dass** die vorbestimmten Kristallebenen die <111>-Ebenen sind.

6. Verfahren nach einem der vorstehenden Ansprüche, **dadurch gekennzeichnet, dass** die wenigstens eine Vertiefung (10) einen Durchbruch (14) durch den Grundkörper (2) bildet.

7. Verfahren nach einem der vorstehenden Ansprüche, **dadurch gekennzeichnet, dass** mehrere Vertiefungen (10) gleichzeitig in die Oberfläche (8) des Grundkörpers (2) eingeätzt werden, die identisch ausgebildet sind.

8. Verfahren nach einem der vorstehenden Ansprüche, **dadurch gekennzeichnet, dass** die Sollbruchstellen (18) in den Grundkörper (2) gesägt werden.

9. Verfahren nach einem der vorstehenden Ansprüche, **dadurch gekennzeichnet, dass** eine Dicke des Grundkörpers (2) auf einen vorbestimmten Wert reduziert wird, bevor der Grundkörper (2) diamantbeschichtet wird oder bevor die Sollbruchstellen (18) eingebracht werden.

10. Diamant-Elektrode (22), herstellbar nach einem Verfahren gemäß einem der vorstehenden Ansprüche.

## Claims

1. A method for producing a diamond electrode (22), comprising the following steps:
a) providing a base body (2) of silicon, having dimensions greater than those of the diamond electrode (22) to be produced,
b) etching at least one recess (10) into the surface (8) of the base body (2),
c) making predetermined breaking points (18) in the base body (2),
d) diamond-coating the base body (2),
e) breaking the diamond electrode (22) out of the base body (2) along the predetermined breaking points (18).

2. The method as claimed in claim 1, **characterized in that** the base body (2) is a single crystal of silicon.

3. The method as claimed in claim 1 or 2, **characterized in that** the at least one recess (10) has at least one flank (12) which extends along a predetermined crystal plane of the base body (2).

4. The method as claimed in claim 3, **characterized in that** the at least one recess (10) has a plurality of, preferably four, flanks (12) of which a plurality, preferably all, extend along a predetermined crystal plane.

5. The method as claimed in claim 3 or 4, **characterized in that** the predetermined crystal planes are the <111> planes.

6. The method as claimed in any of the preceding claims, **characterized in that** the at least one recess (10) forms an aperture (14) through the base body (2).

7. The method as claimed in any of the preceding claims, **characterized in that** a plurality of recesses (10) identical in design are etched simultaneously into the surface (8) of the base body (2).

8. The method as claimed in any of the preceding claims, **characterized in that** the predetermined breaking points (18) are sawn into the base body (2).

9. The method as claimed in any of the preceding claims, **characterized in that** a thickness of the base body (2) is reduced to a predetermined value before the base body (2) is diamond-coated or before the predetermined breaking points (18) are made.

10. A diamond electrode (22) producible by a method as claimed in any of the preceding claims.

## Revendications

1. Procédé de fabrication d'une électrode en diamant (22), comprenant les étapes suivantes consistant à :
a) fournir un corps de base (2) en silicium, dont les dimensions sont supérieures à celles de l'électrode en diamant (22) à fabriquer,
b) graver au moins un renfoncement (10) dans la surface (8) du corps de base (2),
c) réaliser des emplacements destinés à la rupture (18) dans le corps de base (2),
d) revêtir de diamant le corps de base (2),
e) détacher par rupture l'électrode en diamant (22) du corps de base (2) le long des emplacements destinés à la rupture (18).

2. Procédé selon la revendication 1,
**caractérisé en ce que** le corps de base (2) est un monocristal de silicium.

3. Procédé selon la revendication 1 ou 2,
**caractérisé en ce que** ledit au moins un renfoncement (10) présente au moins un flanc (12) qui s'étend le long d'un plan cristallin prédéterminé du corps de base (2).

4. Procédé selon la revendication 3,
**caractérisé en ce que** ledit au moins un renfoncement (10) présente plusieurs, de préférence quatre, flancs (12) dont plusieurs, de préférence tous, s'étendent le long d'un plan cristallin prédéterminé.

5. Procédé selon la revendication 3 ou 4,
**caractérisé en ce que** les plans cristallins prédéterminés sont les plans <1 11 >.

6. Procédé selon l'une des revendications précédentes,
**caractérisé en ce que** ledit au moins un renfoncement (10) forme une traversée (14) à travers le corps de base (2).

7. Procédé selon l'une des revendications précédentes,
**caractérisé en ce que** plusieurs renfoncements (10) sont gravés simultanément dans la surface (8) du corps de base (2) et sont formés de manière identique.

8. Procédé selon l'une des revendications précédentes,
**caractérisé en ce que** les emplacements destinés à la rupture (18) sont sciés dans le corps de base (2).

9. Procédé selon l'une des revendications précédentes,
**caractérisé en ce qu'**une épaisseur du corps de base (2) est réduite à une valeur prédéterminée avant que le corps de base (2) ne soit revêtu de diamant ou avant que les emplacements de rupture solides (18) ne soient réalisés.

10. Électrode en diamant (22) pouvant être fabriquée par un procédé selon l'une des revendications précédentes.
